(19) Europäisches Patentamt

European Patent Office

Office européen des brevets

(11) **EP 2 311 586 A1**

(12) **EUROPEAN PATENT APPLICATION**
published in accordance with Art. 153(4) EPC

(43) Date of publication:
**20.04.2011 Bulletin 2011/16**

(51) Int Cl.:
**B22F 1/00** (2006.01)

(21) Application number: **08792313.2**

(22) Date of filing: **07.08.2008**

(86) International application number:
**PCT/JP2008/064256**

(87) International publication number:
**WO 2010/001496 (07.01.2010 Gazette 2010/01)**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(30) Priority: **30.06.2008 JP 2008171771**

(71) Applicant: **DOWA Electronics Materials Co., Ltd. Chiyoda-ku Tokyo 101-0021 (JP)**

(72) Inventors:
• **IHA, Kosuke**
 **Tokyo 101-0021 (JP)**
• **HISAEDA, Yutaka**
 **Tokyo 101-0021 (JP)**
• **UEYAMA, Toshihiko**
 **Tokyo 101-0021 (JP)**

(74) Representative: **Haley, Stephen**
 **Gill Jennings & Every LLP**
 **The Broadgate Tower**
 **20 Primrose Street**
 **London EC2A 2ES (GB)**

(54) **METAL MICROPARTICLE CONTAINING COMPOSITION AND PROCESS FOR PRODUCTION OF THE SAME**

(57)     A metal-containing composition that can provide, by low-temperature heat treatment, a sintered state comparable to that obtained by high-temperature heat treatment, a conductive paste, a metal film are provided. A method for manufacturing a metal-containing composition that can manufacture the metal-containing composition by simple operation steps is also provided. The metal-containing composition contains fine metal particles, and the ratio $\rho_f$ of a true density $\rho_{200}$ to a true density $\rho_{150}$ (= $\rho_{200}/\rho_{150}$) is 1.10 or less where $\rho_{150}$ is the true density of the metal-containing composition after heating at 150°C for 60 minutes, and $\rho_{200}$ is the true density after heating at 200°C for 60 minutes. The ratio of $\rho_{150}$ to $\rho_M$ ($\rho_{150}/\rho_M$) and the ratio of $\rho_{200}$ to $\rho_M$ ($\rho_{200}/\rho_M$) are 0.8 or more, where $\rho_M$ is the density of the fine metal particles in a bulk form. An organic material having a molecular weight of 200 or less is caused to adhere to the fine metal particles. The metal-containing composition is manufactured by: a step of preparing a solution by mixing water, ammonia water, an organic material having a molecular weight of 200 or less, and a reducing agent; a step of adding an aqueous solution of a metal salt to the prepared reducing solution to allow the reaction to occur; and a step of filtrating the obtained product and washing the product with water.

EP 2 311 586 A1

**Description**

TECHNICAL FIELD

The present invention relates to a metal-containing composition exhibiting good conductivity even after baking at low temperatures and to a method for manufacturing the same.

BACKGROUND ART

In recent years, fine metal particles of nanometer size (metal nanoparticles) are being used in various fields. For example, in the field of conductive materials, attempts are being made to draw a fine electric wiring pattern using a conductive paste containing metal nanoparticles by a printing technique such as an ink-jet technique. Attempts are also being made to enable the formation of a conductive film on a low heat resistant substrate such as paper by utilizing the low-temperature sinterability specific to nanometer size particles. Therefore, there is a strong demand for a paste having properties suitable for these objects.

The desired properties of metal nanoparticles needed to achieve the above objects are as follows. First, the metal nanoparticles have good dispersibility in a dispersion medium for a paste. In the step of heat treatment after application of the paste, the metal nanoparticles can be sintered by heat treatment at low temperatures (about 200˚C) at which even a low heat resistant substrate can be used, and the sintered product exhibits good conductivity. Second, the metal nanoparticles in a dry powder form are stable and can be re-dispersed in various solvents in accordance with need. This provides good handleability when a dispersion composition or an ink composition is produced, and these compositions can be produced at various composition ratios using various manufacturing methods. To meet the second desired properties, it is preferable from the industrial point of view that, after completion of the reaction for manufacturing the metal nanoparticles, they can be easily separated from a reaction solvent in the reaction mixture in a short period of time using a conventionally used apparatus such as a filter press.

To achieve these objects, various attempts have been made to produce metal nanoparticles using different methods. Generally, to achieve the first desired properties, an organic material is caused to adhere to the surfaces of metal nanoparticles for the purpose of suppressing fusion of the surfaces of the metal nanoparticles during or after the reaction. In one widely used method, an organic material having a relatively large molecular weight is caused to adhere to the surfaces to ensure the independence of the particles. However, when the particles are fusion-bonded after the dispersion thereof is applied to a substrate, the substrate must be heated at high temperatures for a long period of time in the process of volatilization of the organic material covering and surrounding the particles, because of the large molecular weight of the organic material. One problem in this case is that it is difficult to use a material having a relatively low glass transition temperature, i.e., having low heat resistance, for the substrate. To solve this problem, it is necessary to provide particles that can be sintered by baking at as low temperatures as possible in a short period of time.

To solve the above problem, molecules that vaporize at low temperatures are used as a protective agent in Patent Document 1. This succeeds in providing a metal film exhibiting a relatively good volume resistivity value, for example, of 6.8 to 9.5 $\mu\Omega$-cm, even when heat treatment is performed at a low temperature of 150˚C. However, the above resistivity value is still higher than 1.6 $\mu\Omega$-cm of the resistivity value of bulk silver.

In addition, to provide particles using the disclosed particle manufacturing method, solid-liquid separation must be performed by centrifugation. Therefore, the separation and collection of the particles take a large amount of time. From the industrial point of view, there is a demand for a simple manufacturing method that enables solid-liquid separation in a short period of time.

Examples of the means for achieving solid-liquid separation easily in a short period of time include the method disclosed in Patent Document 2. Patent Document 2 discloses that, with the method disclosed, silver nanoparticles can be produced by mixing an aqueous solution of silver nitrate with an aqueous mixture of an aqueous solution of ferric sulfate and an aqueous solution of sodium citrate. More specifically, formed silver nanoparticles aggregate rapidly during reaction with the aid of high-concentration iron, sodium, and other ions originating from the raw materials, and aggregates of silver nanoparticles protected by citric acid ions are thereby formed. Since the aggregates are obtained with the surfaces of the particles protected after the reaction, the aggregates can be separated from the reaction solvent by ordinary solid-liquid separation means such as a filter press. When pure water is added to the cake of the aggregates, the concentrations of iron ions and sodium ions in the solution become low. Therefore, the cause of aggregation is eliminated, and the silver nanoparticles can be re-dispersed.

However, it is very difficult to almost completely remove impurities such as sodium from the powder. Therefore, in an ink that can be produced by the above method, impurities may still remain present on, for example, the surfaces of the metal nanoparticles. The ions of these impurities may adversely affect the conductivity of a baked metal film for some ink compositions. The concentrations of the impurities may be reduced by repeated washing. However, since washing and filtration are performed under the condition that the cause of aggregation is reduced, it is considered that aggregates may not be easily formed. Therefore, a complicated and time consuming operation such as long-time decantation or centrifugation is required when filtration is performed after washing, and this method may not be suitable from the industrial point of view.

Patent Document 1: Japanese Patent Application Laid-Open No. 2007-95510
Patent Document 2: Japanese Patent Application Laid-Open No. 2006-28637

DISCLOSURE OF THE INVENTION

PROBLEMS TO BE SOLVED BY THE INVENTION

The present invention has been devised in view of the above problems in the conventional technologies, and it is an object of the present invention to provide a metal-containing composition that includes a metal component easily separated from a reaction solution and can provide, by low temperature heat treatment, a sintered state comparable to the sintered state obtained conventionally by high temperature heat treatment. It is also an object of the present invention to provide a method for manufacturing the above metal-containing composition.

MEANS FOR SOLVING THE PROBLEMS

The present inventors have conducted extensive studies and found that particles exhibiting sufficient conductivity even after low temperature heat treatment and having excellent separability and collectability can be obtained by using a specific organic component to form the surfaces of the metal particles. These particles can be obtained by a manufacturing method including reacting an aqueous solution of a metal salt with a reducing solution prepared by mixing water, ammonia water, an organic material having a molecular weight of 200 or less, and a reducing agent and then filtrating and washing the resultant particles.

More specifically, a metal-containing composition of the present invention includes fine metal particles having an average particle diameter of less than 100 nm. In the metal-containing composition, $\rho_f$ is 1.10 or less where $\rho_f$ is a ratio of a true density $\rho_{200}$ to a true density $\rho_{150}$ ($\rho_{200}/\rho_{150}$), $\rho_{150}$ is the true density of the metal-containing composition after heating in air at 150˚C for 60 minutes, and $\rho_{200}$ is the true density of the metal-containing composition after heating in air at 200˚C for 60 minutes.

In one preferred embodiment of the metal-containing composition of the present invention, a ratio of $\rho_{150}$ to $\rho_M$ ($\rho_{150}/\rho_M$) and/or a ratio of $\rho_{200}$ to $\rho_M$ ($\rho_{200}/\rho_M$) is 0.8 or more, where $\rho_m$ is a density of the fine metal particles in a bulk form.

In another preferred embodiment of the metal-containing composition of the present invention, the fine metal particles have surfaces with an organic material with a molecular weight of 200 or less adhering thereto.

A method for manufacturing a metal-containing composition of the present invention includes: a reducing solution preparing step of preparing a reducing solution by mixing water, ammonia water, an organic material having a molecular weight of 200 or less, and a reducing agent; a reaction step of adding an aqueous solution of a metal salt to the reducing solution to allow a reaction to occur; and a filtrating-washing step of filtrating a product obtained in the reaction step and washing the product with water.

EFFECTS OF THE INVENTION

The metal-containing composition of the present invention contains fine metal particles and is formed such that the true densities after heat treatment at 150˚C and 200˚C are nearly the same. Therefore, a sintered state comparable to that after high temperature heat treatment can be easily obtained even by low temperature heat treatment.

The method for manufacturing a metal-containing composition of the present invention includes simple operation steps including reacting an aqueous solution of a metal salt with a reducing solution prepared by mixing water, ammonia water, an organic material having a molecular weight of 200 or less, and a reducing agent and then filtrating and washing the product.

BRIEF DESCRIPTION OF THE DRAWINGS

Fig. 1 is a diagram showing the relationship between a true density ratio and volume resistivity.
Fig. 2 is a diagram showing the relationship between a density ratio and volume resistivity in a bulk form.

Fig. 3 is a SEM photograph of a metal-containing composition of the present invention after filtration, washing, and drying.

Fig. 4 is a TEM image of the dry powder in Fig. 3 taken after re-dispersion in a solvent.

Fig. 5 is a surface SEM photograph of Example 2 (150) obtained by baking a silver powder in Example 1 in air at 150˚C for 60 minutes.

Fig. 6 is a surface SEM photograph of Example 2 (200) obtained by baking the silver powder in Example 1 in air at 200˚C for 60 minutes.

Fig. 7 is a surface SEM photograph of Example 3 (150) obtained by drying the silver powder in Example 1 in air at 100˚C for 60 minutes and baking it at 150˚C for 30 minutes.

Fig. 8 is a surface SEM photograph of Comparative Example 2 (150) obtained by baking a silver powder in Comparative Example 1 in air at 150˚C for 60 minutes.

Fig. 9 is a surface SEM photograph of Comparative Example 2 (200) obtained by baking the silver powder in Comparative Example 1 in air at 200˚C for 60 minutes.

BEST MODE FOR CARRYING OUT THE INVENTION

Hereinafter, a metal-containing composition of the present invention will be described in detail. The fine metal particles contained in the metal-containing composition of the present invention are fine metal particles of the order of nanometers. Therefore, the metal-containing composition of the present invention is also referred to as a metal nanoparticle-containing composition. The metal nanoparticle-containing composition includes a powder of metal nanoparticles, a dispersion in which metal nanoparticles are dispersed, and the like.

In the present invention, aggregation means a state in which two or more particles come close to each other to form an aggregate with their surfaces not in contact with each other. Coagulation means that two or more particles coalesce to form one particle.

The metal nanoparticle-containing composition of the present invention has a property that a true density ratio $\rho_f$ represented by equation (1) is 1.10 or less.

$$\rho_f = \rho_{200} / \rho_{150} \qquad (1)$$

where $\rho_{150}$ is a true density after heating in air at 150˚C for 60 minutes and $\rho_{200}$ is a true density after heating in air at 200˚C for 60 minutes.

The true density ratio $\rho_f$ means that, as its value approaches 1.00, a change in sinterability at different temperatures decreases. More specifically, if the absolute value of the true density at 200˚C is close to that of a bulk metal, the sintering behavior at low temperatures is similar to the sintering behavior at higher temperature. In other words, this means that the sinterability at low temperatures is good. A true density ratio $\rho_f$ exceeding 1.10 means that the difference between the value of $\rho_{150}$ after heat treatment at 150˚C and the value of $\rho_{200}$ after heat treatment at 200˚C is large. If the true density at 200˚C is close to that of a bulk metal, the sinterability at relatively high temperature differs from that at low temperatures, and this means that such a metal nanoparticle-containing composition has poor sinterability at low temperatures. Therefore, the value of the true density ratio $\rho_f$ is preferably 1.05 or less and more preferably 1.02 or less.

The present invention is also **characterized in that** the ratios of $\rho_{150}$ and $\rho_{200}$ to a density $\rho_M$ of the fine metal particles in a bulk form that are contained in the metal-containing composition (the ratios ($\rho_{150} / \rho_M$) and ($\rho_{200} / \rho_M$)) are 0.80 or more. Each of these ratios is a measure that indicates how the metal after heating is close to a pure metal and also indicates the degree of ease of desorption of the organic component adhering to the surface at the indicated temperature and therefore the ratio of the pure metal in the remaining particles. These ratios are ideally 1. The density in a bulk form is the weight per cubic centimeter of the metal element that constitutes the fine metal particles when the metal element is in a stable state at room temperature. Any one or both of a single substance of gold, silver, or copper and a compound containing any combination of these metals can be used as the metal element.

The ratios of the true densities after heat treatment at 150˚C and 200˚C to the density of the metal in a bulk form indicate that the closer the ratios to 1.00 is, the larger the amount of coating molecules removed during low temperature heat treatment is. Therefore, in such a case, no unwanted component is present on the surfaces of the metal nanoparticles, and the contact area increases. This may cause an increase in sintered (bonded) portions at low temperatures, resulting in good conductivity even at low temperatures.

If these ratios are less than 0.80, the organic component may remain present on the surfaces of the metal nanoparticles, and this means that the organic component may not be desorbed from these surfaces. Therefore, the area of the exposed surfaces of the metal nanoparticles may be small, and this may result in poor sinterability (bondability) of the particles at low temperatures and poor conductivity. These ratios are preferably 0.90 or more and more preferably 0.95 or more. When these ratios have the above values, conductivity comparable to that of a metal in a bulk form can be obtained if the true density after baking is close to the density in the bulk form.

Preferably, an organic material including a group having affinity with metal is disposed on the surfaces of the metal nanoparticles. Examples of such an organic material include straight chain fatty acids that function as a protective agent. The organic material has a molecular weight of preferably 200 or less from the viewpoint of ease of evaporation during baking. More preferably, the molecular weight is 150 or less.

Another difference of the metal nanoparticles in the present invention from many types of conventional metal nanoparticles is the ease of separation of particles. In one well-known conventional method of synthesizing metal nanoparticles, the metal nanoparticles immediately after synthesis are dispersed in a reaction solvent. Therefore, solid-liquid separation is conventionally performed using a complicated or time consuming method such as long-time decantation or centrifugation, and this is not industrially advantageous.

However, in the metal nanoparticle-containing composition of the present invention, the metal nanoparticles are aggregated during manufacturing by appropriately adjusting the composition of the organic material present on the surfaces of the fine metal particles. Therefore, the nanoparticles can be separated using a paper filter or an existing facility such as a filter press, which are conventionally used to collect particles of the order of micrometers. The metal nanoparticlecontaining composition obtained in the present invention can be stable even in a dried state and is therefore less bulky, and this is highly advantageous in transportation and storage.

This mechanism is not clear at the present time but may be due to the hydrophobicity of the metal nanoparticles. For example, when hexanoic acid having a hydrophilic COOH group and a hydrophobic C chain is used as a protective agent, COO-may be oriented toward the particle surface, and the hydrophobic C chain may be oriented toward the outside (the water side during reaction). When water is used as a reaction solvent, the hydrophobic particles are gathered to form large aggregates, and solid-liquid separation can be easily performed using, for example, a filter press.

In the metal nanoparticle-containing composition of the present invention, the aggregated particles in a dry powder form after solid-liquid separation are stable and can be re-dispersed in a suitable dispersion medium. Although this mechanism is not clear, the influence of multiple adsorption of the organic material functions as a protective agent on the surfaces of the metal nanoparticles may allow the aggregation after the reaction and re-dispersion in the dispersion medium.

Next, a conductive paste of the present invention will be described. The conductive paste of the present invention is produced by concentrating or diluting the above metal nanoparticle-containing composition with a dispersion medium in accordance with need. This enables production of electric wiring or a conductive film on various substrate materials using low-temperature heat treatment.

Preferably, a polar solvent is selected as the dispersion medium. Examples of the dispersion medium include water, alcohols, polyols, glycol ethers, 1-methyl pyrrolidinone, pyridine, terpineol, texanol, butyl carbitol, and butyl carbitol acetate.

Next, a method for manufacturing the metal nanoparticle-containing composition of the present invention will be described. In the method for manufacturing the metal nanoparticle-containing composition of the present invention, a reducing solution preparing step, a silver reaction step, and a filtrating-washing step are performed to obtain the metal nanoparticle-containing composition.

The metal nanoparticle-containing composition can be manufactured by, for example, a solution preparing step of preparing a raw material solution and a reducing solution, a temperature increasing step of increasing temperature, a reaction step of adding the raw material solution to the reducing solution to progress the reaction, a ripening step of growing metal particles (in particular, silver particles) in the resultant solution, a filtrating-washing step of removing the excess organic material by filtration and washing, and a drying step of removing water in the solution by drying.

The reducing solution used in the reducing solution preparing step contains water, ammonia water, an organic material functioning as a protective agent, and a reducing agent. The molecular weight of the organic material is 200 or less. The ammonia water acts as a stabilizer for dissolving acid in water. Preferably, the organic material functioning as the protective agent has a group having affinity with the surfaces of particles, and examples of the organic material include straight chain fatty acids. The molecular weight of the organic material is preferably 150 or less from the viewpoint of ease of evaporation during baking.

Any reducing agent may be used so long as it allows reduction to metal. The reducing agent used may be appropriately selected from hydrazine hydrate, hydrazine, alkali salts of borohydride (such as $NaBH_4$), lithium aluminum hydride ($LiAlH_4$), ascorbic acid, primary amines, secondary amines, and tertiary amines.

In the reaction step, an aqueous solution of a metal salt is added to the reducing solution to allow the reaction to occur. Preferably, in this reaction step, the reaction is performed in a reaction tank heated in the range of 40°C to 80°C. More preferably, the temperature of the aqueous solution of the metal salt to be added to the reaction tank is adjusted to the temperature of the reaction tank. If the temperature in the reaction tank is less than 40°C, the degree of supersaturation of the metal increases, and nucleation is promoted, so that the amount of fine particles is likely to increase. If the temperature is higher than 80°C, nucleation is suppressed, but growth and aggregation of particles are likely to be promoted.

In the reaction step, it is preferable, from the viewpoint of achieving uniform reaction in a solution, that the entire amount of the aqueous metal salt solution to be added should be added at once. If the entire amount is not added at once, an inhomogeneous solution is formed, and nucleation and aggregation of particles occur simultaneously. This may result in inhomogeneous metal particles having a wide size distribution. No particular limitation is imposed on the manner of "adding the entire amount at once," so long as the reaction factors such as the concentrations, pHs, and temperatures of the reducing agent and the protective agent are not substantially changed by the addition timing of the aqueous metal salt solution.

In the filtrating-washing step, the reaction product obtained in the reaction step is washed with water. No particular limitation is imposed on the method used in the filtration-water washing step. From the industrial point of view, a method in which solid-liquid separation is performed by filtrating a reaction solution through a filer cloth is more preferable than centrifugation and decantation, and a filter press, for example, may be used as the filtration apparatus.

In the method for manufacturing the metal nanoparticle-containing composition described above, a reaction tank having a shape and structure that can provide uniform stirring is preferably used. This is because the particle size distribution of the metal nanoparticles obtained by the reduction reaction is largely affected by the local concentration and pH distributions since the size of the particles to be obtained is very small.

Next, the manufacturing steps in one embodiment of the method for manufacturing fine silver particles in the present invention are described by following the flow of the reaction. Preferably, the reaction is performed in an inert gas atmosphere such as nitrogen, and nitrogen is ventilated to remove oxygen dissolving in a solution.

<Solution Preparing Step>

In this step, raw solutions for the reaction are prepared, and two types of solutions are prepared as the raw solutions. One of the raw solutions is solution I (which may later be referred to as a reducing solution) containing a reductive material dissolved therein, and the other is solution II (which may later be referred to as a raw material solution) containing, dissolved therein, a metal salt (in particular, a silver salt) used as a raw material. The reducing solution is obtained by dissolving the reducing agent in pure water, adding a protective agent and ammonia water thereto, and mixing the resultant mixture until uniform. The raw material solution is obtained by dissolving crystals of the metal salt in pure water.

<Temperature Increasing Step>

After these solutions are prepared, the temperatures of the solutions are increased to a reaction temperature using a water bath or heater. Preferably, the reducing solution and the reaction solution are heated similarly. This can provide an effect of preventing the reaction from proceeding inhomogeneously, so that the homogeneity of the particles can be ensured. The target temperature (the temperature of the reaction to be performed) during temperature rise is in the range of 40 to 80˚C.

<Reaction Step>

After the temperatures of the solutions rise to the target temperature, the reducing solution and the raw material solution are mixed. It is preferable in terms of the homogeneity of the reaction that the entire amount be added at once while care is taken to prevent bumping.

<Ripening Step>

After the mixed reaction solution is obtained, this solution is stirred continuously for 10 to 30 minutes to complete the reaction. The endpoint of the reaction is determined by adding hydrazine dropwise to a sampled reaction solution to determine whether or not the reduction reaction still occurs.

<Filtrating-Washing Step>

The obtained slurry is subjected to solid-liquid separation using a filter press, and the obtained cake is washed. Preferably, the washing is continued until an electric conductivity equal to that of pure water used as the washing solution is obtained, and the washing step is then terminated.

<Drying Step>

The washed cake is dried in a vacuum at 40˚C for 12 hours to obtain dried metal particle aggregates.

Examples

Hereinafter, Examples will be described in detail.

(Example 1)

(1) Production of metal nanoparticle-containing composition

A 24L reaction tank was used. Baffle plates were disposed at regular intervals on the inner side of the walls to ensure uniformity of stirring. A stirring rod having two turbine blades for stirring was disposed at the center of the reaction tank. A thermometer for monitoring temperature was placed in the reaction tank. A nozzle was placed to supply nitrogen to a solution from the lower portion.

First, the reaction tank was charged with 16851 g of water, and nitrogen was fed from the lower portion of the reaction tank at a flow rate of 5000 mL/min for 600 seconds to remove remaining oxygen. Then nitrogen was fed from the upper portion of the reaction tank at a flow rate of 5000 mL/min to create a nitrogen atmosphere in the reaction tank.

The rotation speed of the stirring rod was adjusted to 338 rpm. Temperature adjustment was performed such that the temperature of the solution in the reaction tank was 60˚C.

33.9 g of ammonia water (containing 30% of ammonia) was fed to the reaction tank, and then the resultant solution was stirred for 1 minute to obtain a uniform solution.

Next, 218.3g of hexanoic acid (1.98 equivalent of silver) (special grade reagent, product of Wako Pure Chemical Industries, Ltd.) used as the protective agent was added, and the resultant mixture was stirred for 4 minutes to dissolve the protective agent. Then 114.5 g of a 50% aqueous solution of hydrazine hydrate (product of Otsuka Chemical Co., Ltd.) used as the reducing agent was added, and the resultant mixture was used as the reducing solution.

An aqueous solution of silver nitrate prepared by dissolving 162 g of silver nitrate crystals (special grade reagent, product of Wako Pure Chemical Industries, Ltd.) in 438 g of water was prepared in a separate container and used as the raw material solution. The temperature of the aqueous solution of silver nitrate was adjusted to 60˚C, which was the same as the temperature of the solution in the reaction tank.

Next, the entire amount of the raw material solution was added to the reducing solution at once to allow the reduction reaction to occur. The reaction mixture was continuously stirred and ripened for 10 minutes under stirring. Then the stirring was terminated, and the reaction mixture was subjected to solid-liquid separation by suction filtration. A powder containing silver nanoparticles was obtained after the washing step and the drying step.

(2) Baking of powder

The powder obtained in the above process was spread over a square ash tray for ash measurement at a thickness of approximately 2 mm and baked in a heating furnace (muffle furnace FO310, product of Yamato Scientific Co., Ltd.) in air at 150˚C for 60 minutes or at 200˚C for 60 minutes. To distinguish the baked samples, the sample baked at 150˚C is referred to as Example 1 (150), and the sample baked at 200˚C is referred to as Example 1 (200). Each Example 1 is a baked powder.

(3) Measurement of true density

Each powder obtained in the baking step was measured for its true density using ULTRAPYCNOMETER 1000 (product of Quantachrome Instruments) . The values of $\rho_f$, ($\rho_{200}$ / $\rho_M$), and ($\rho_{150}$ / $\rho_M$) were computed using the values obtained in the measurement. A known value in a literature was used as $\rho_M$.

(Example 2)

(1) Production, application, and baking of paste

6.0 g of the silver powder obtained in (1) for Example 1 was kneaded with 4.0 g of terpineol to produce a silver paste having a silver concentration of 60 percent by mass. A coating of the obtained silver paste was formed on a glass slide using an applicator. The coating was baked in a heating furnace in air at 150˚C for 60 minutes or at 200˚C for 60 minutes. Also in Example 2, the product baked at 150˚C is referred to as Example 2 (150), and the product baked at 200˚C is referred to as Example 2 (200). Each Example 2 is a film obtained by baking the paste.

(2) Measurement of volume resistivity

The volume resistivity of each baked film obtained in (1) above was measured using Loresta (registered trademark, product of Mitsubishi Chemical Corporation).

(Example 3)

(1) Production, application, and baking of paste

5.0 g of the silver powder obtained in (1) for Example 1 was kneaded with 5.0 g of terpineol to produce a silver paste having a silver concentration of 50 percent by mass. A coating of the obtained silver paste was formed on a glass slide using an applicator. The coating was dried in air at 100˚C for 60 minutes to evaporate the solvent in the coating and then baked in air at 150˚C for 30 minutes.
Also in Example 3, the product baked at 150˚C is referred to as Example 3 (150), and Example 3 is a film obtained by baking the paste.

(2) Measurement of Volume Resistivity

The volume resistivity of the baked film obtained in (1) above was measured in the same manner as in (2) for Example 2.

(Comparative Example 1)

A silver powder coated with oleylamine was produced. First, 50 mg of silver acetate was dissolved in 2.0 g oleylamine, and the resultant solution was introduced into 50 ml of refluxing hexane. This state was maintained for 2 days. In the state after the reaction, fine particles were dispersed in the reaction solvent, and solid-liquid separation by suction filtration was not possible. Therefore, the reaction solvent was removed by centrifugation. Then the product was washed twice with methanol and dried to obtain a dry powder. The silver powder obtained as Comparative Example 1 was manufactured by a method different from that for the Example. The operations (2) and (3) for Example 1 were also performed for the obtained silver powder. The results obtained for the Examples and Comparative Example are shown in Table 1.

(Comparative Example 2)

The operation for Example 2 was performed using the silver nano-powder of Comparative Example 1. In summary, each Example 1 is a silver powder obtained by baking the metal-containing composition of the present invention; each Example 2 is a baked film obtained by baking a film of a paste prepared using Example 1; and Example 3 is a film obtained under different baking conditions from those for Example 2. Each Comparative Example 1 is a silver powder obtained by baking a metal-containing composition produced by a manufacturing method different from that for Example 1, and each Comparative Example 2 is a baked film obtained by baking a film of a paste prepared using Comparative Example 1. Specific surface area measurement by the BET method was carried using 4S-U2 (product of Yuasa Ionics Inc.). TAP density measurement was carried out using a measurement method described in Japanese Patent Application Laid-Open No. 2007-263860.
As the amounts of impurities in the powders, the amounts of N, O, and C in the powders of Example 1 and Comparative Example 1 were measured before and after baking. The amount of C remaining in the baked film of Example 3 was measured. The measurement for N and O was performed by the inert gas fusion-infrared absorption method using an oxygen/nitrogen simultaneous analyzer (Type TC-436, product of LECO). The measurement for C was performed by the combustion method using a carbon-sulfur analyzer (EMIA-220V, product of HORIBA Ltd.).
The reduction ratio of the amount of C contained in the metal nanoparticle-containing composition before and after baking at 150˚C for 60 minutes (the amount of C after baking / the amount of C before baking) is preferably less than 0.30, more preferably less than 0.20, and further preferably less than 0.15. If the reduction ratio of the C amount is 0.30 or more, the conductivity of the baked film may be poor because the removal ratio of C by baking is low. The lower the C amount is, the higher the purity of silver in the baked film is. Therefore, the lower the reduction ratio of the C amount before and after baking is, the more it is preferable. Accordingly, the lower limit of the reduction ratio of the C amount before and after baking cannot be defined. The percent by mass of C is the ratio of the mass of C to the total mass of a powder.

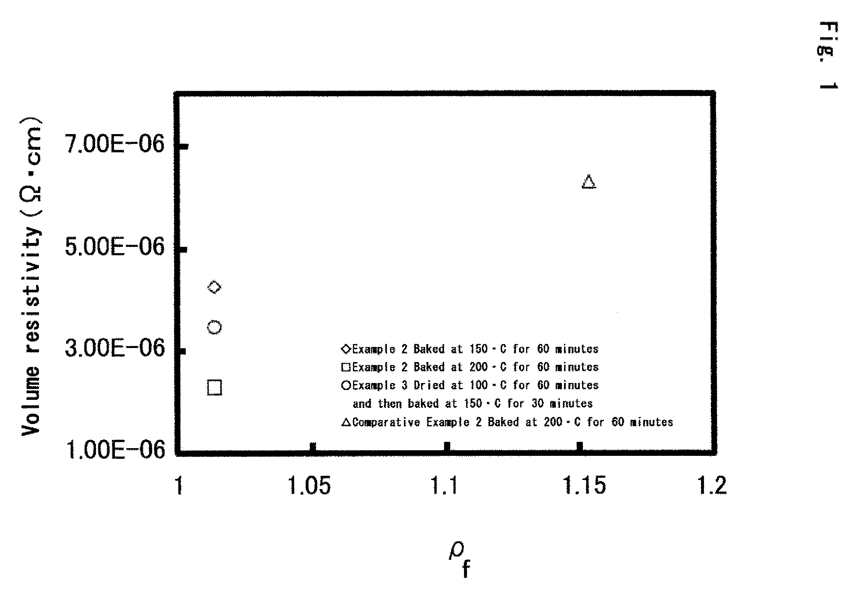

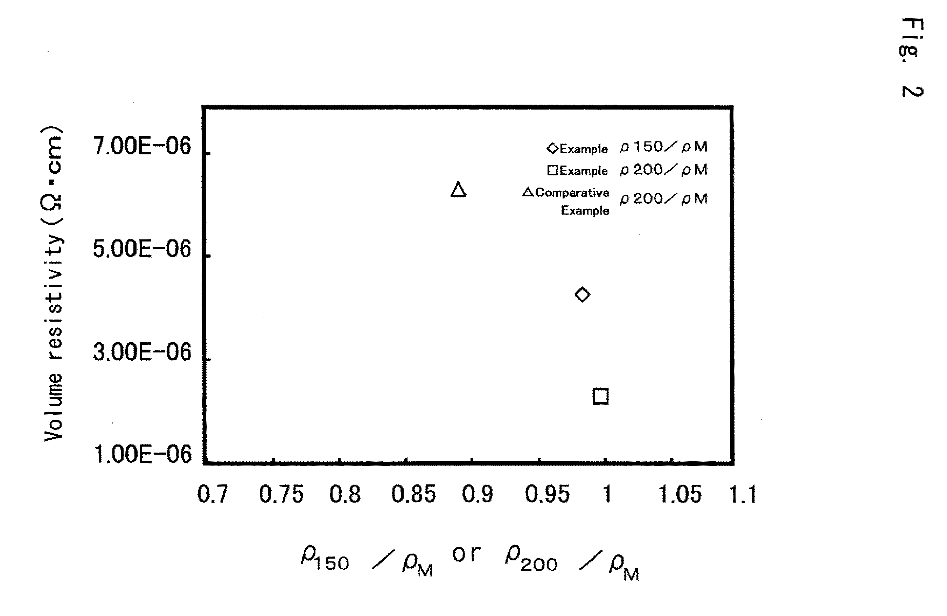

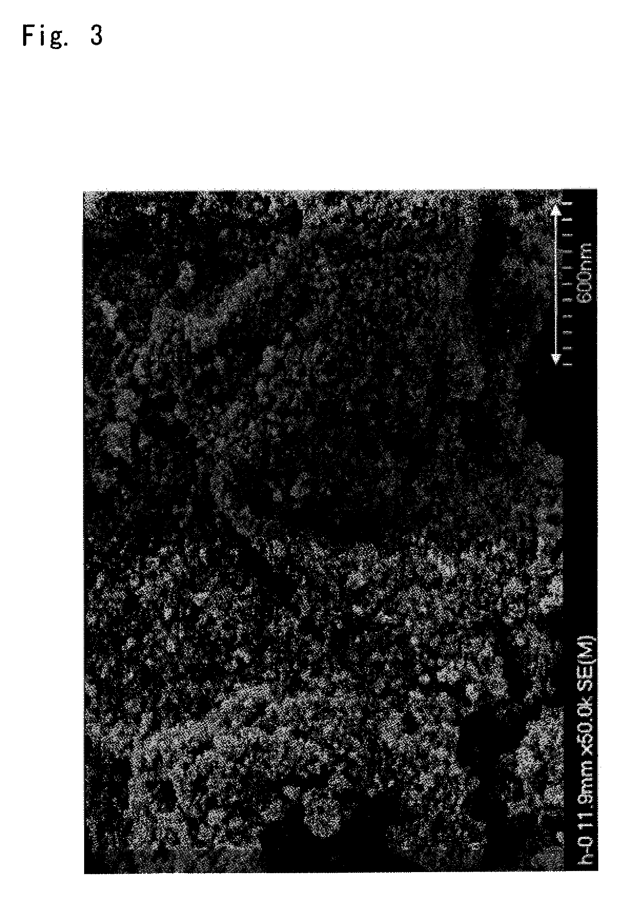

The results obtained for the Examples and Comparative Examples are shown in Tables 1 and 2 and Figs. 1 and 2. SEM images of the surfaces of the baked films of Example 2, Example 3, and Comparative Example 2 are shown in Figs. 3 to 9.

[Table 1]

| | | Baking temperature (˚C) | Baking Time | BET (m²/g) | TAP (g/cm³) | N (Percent by mass) | O (Percent by mass) | C (Percent by mass) | True density (g/cm³) | $\rho_f$ | $\dfrac{\rho_{150}}{\rho_M}$ | $\dfrac{\rho_{200}}{\rho_M}$ |
|---|---|---|---|---|---|---|---|---|---|---|---|---|
| Example 1 | Powder before baking | - | - | 19.3 | 2.35 | 0.048 | 0.883 | 1.475 | 8.56 | 1.01 | - | - |
| | Powder after baking | 150 | 60 | - | - | 0.004 | 0.143 | 0.16 (0.11) | 10.33 | - | 0.98 | - |
| | Powder after baking | 200 | 60 | - | - | <0.001 | 0.084 | 0.023 (0.02) | 1 0.47 | - | - | 1 .00 |
| Example 3 | Baked film | 150 | 30 | - | - | - | - | 0.072 | - | - | - | - |
| Comparative Example 1 | Powder before baking | - | - | 0.237 | 2.162 | 0.813 | 0.381 | 11.7 | 5.26 | 1.15 | - | - |
| | Powder after baking | 150 | 60 | - | - | 0.285 | 0.251 | 4.39 (0.38) | 8.10 | - | 0.77 | - |
| | Powder afterbaking | 200 | 60 | - | - | 0.209 | 0.106 | 1.04 (0.09) | 9.34 | - | - | 0.89 |

[Table 2]

|  | Baking temperature (˚C) | Baking time (minute) | Volume resistivity [Ω·cm] |
|---|---|---|---|
| Example 2 | 150 | 60 | $4.26 \times 10^{-6}$ |
|  | 200 | 60 | $2.28 \times 10^{-6}$ |
| Example 3 | 150 | 30 | $3.47 \times 10^{-6}$ |
| Compara tive Example 2 | 150 | 60 | Resistivity not measured |
|  | 200 | 60 | $6.32 \times 10^{-6}$ |

Table 1 shows the values of baking temperature, baking time, BET, TAP density, mass ratios of N, O, and C, true density, true density ratio $\rho_f$, $\rho_{150} / \rho_M$, and $\rho_{200} / \rho_M$ of each powder of Example 1 and Comparative Example 1. The baking temperature, baking time, and the percent by mass of C after baking of the baked film of Example 3 are also shown. Table 2 shows the values of baking temperature, baking time, and volume resistivity of each of Example 2, Example 3, and Comparative Example 2. In Table 1, the values inside the parentheses in the column of the mass ratio of C are the reduction ratios before and after baking at 150˚C or 200˚C for 60 minutes (the amount of C after baking / the amount of C before baking).

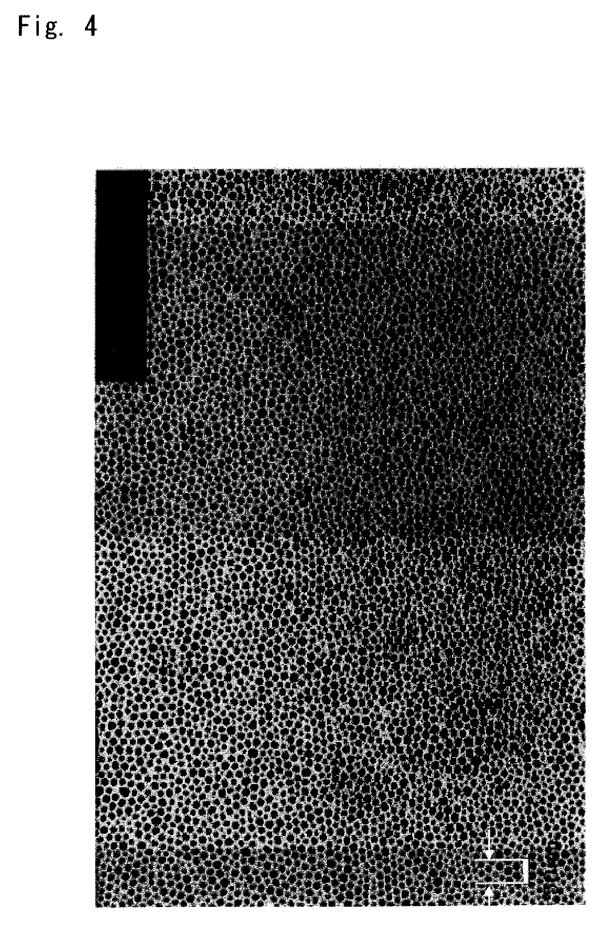

Fig. 3 is a SEM photograph of the metal-containing composition of the present invention after filtration, washing, and drying. The arrows in the figure represent 600 nm. Fine particles observed were clearly of the order of nanometers and were clustered. This shows that the metal-containing composition of the present invention was formed as aggregates of fine primary particles of the order of nanometers. Fig. 4 is a TEM image taken after the dried powder in Fig. 3 was re-dispersed in a solvent. The space between arrows represents 50 nm. The primary particle size determined from the image was 14 nm. In the dried powder state, these primary particles were aggregated to form aggregates.

Next, Fig. 1 is referred to. Fig. 1 is a graph showing the relationship between the true density ratio $\rho_f$ of a metal-containing composition and the volume resistivity of a film produced from a paste of the metal-containing composition after baking. The triangle represents a sample (Comparative Example 2) prepared by baking the silver powder of Comparative Example 1 in air at 200˚C for 60 minutes. The square represents a sample (Example 2 (200)) prepared by baking the silver powder of Example 1 in air at 200˚C for 60 minutes. The diamond represents a sample (Example 2 (150)) prepared by baking the silver powder of the Example in air at 150˚C for 60 minutes. The circle represents a sample (Example 3) prepared by drying the silver powder of Example 1 in air at 100˚C for 60 minutes and baking the dried powder in air at 150˚C for 30 minutes. The square, circle, and diamond represent the volume resistivities of the baked films (Examples 2 and 3) prepared using the metal-containing composition of Example 1, and therefore the true density ratios $\rho_f$ are the same (1.01).

However, in the Comparative Examples, the true density ratio of the metal-containing composition of Comparative Example 1 was 1.15, and the volume resistivity of the baked film (Comparative Example 2) produced by baking the coating of the paste of this metal-containing composition at 200˚C for 60 minutes was higher than those of the Examples when baking was performed in air at 150˚C (Examples 2 and 3). More specifically, the Comparative Examples had the true density ratio $\rho_f$ and the volume resistivity that were higher than those of the Examples. The comparison results between Examples 2 and 3 showed that the volume resistivity of Example 3 (drying in air at 100˚C for 60 minutes and baking in air at 150˚C for 30 minutes) was better than that of Example 2 (baking in air at 150˚C for 60 minutes). Since the baking time at 150˚C was shorter for Example 3, it may be considered that the sintering of the particles proceeded to some extent during drying at 100˚C for 60 minutes. As can be seen also from these results, the metal-containing composition of the present invention has good low temperature sinterability.

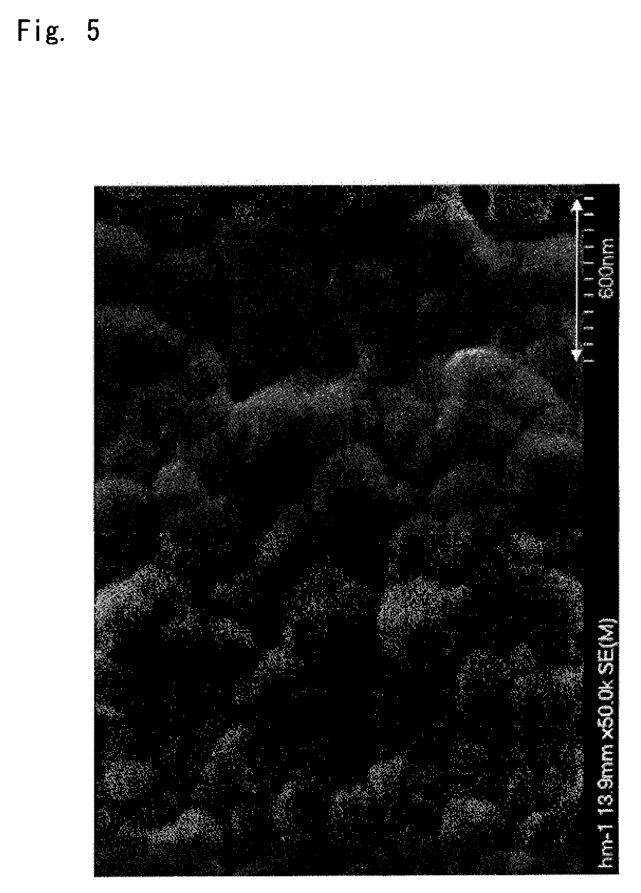

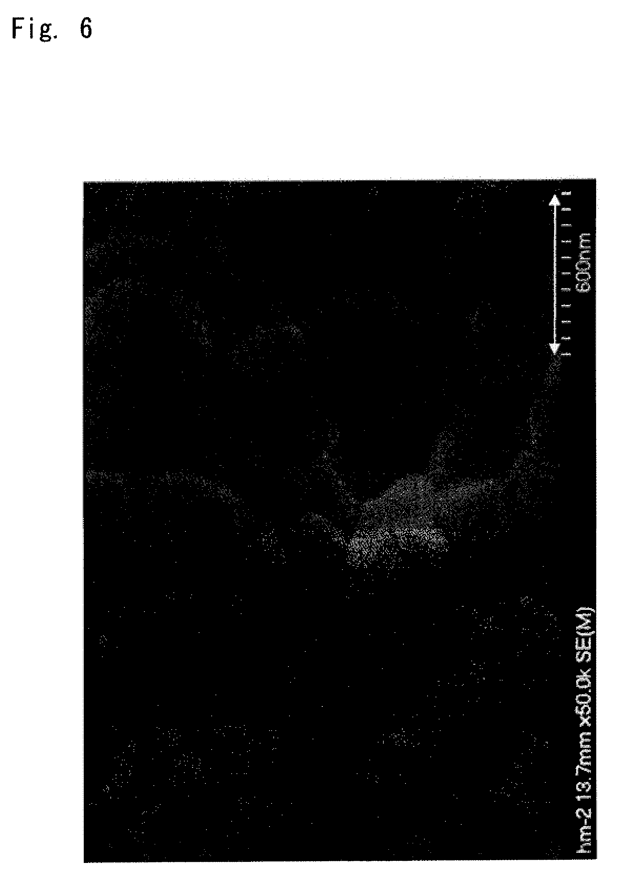

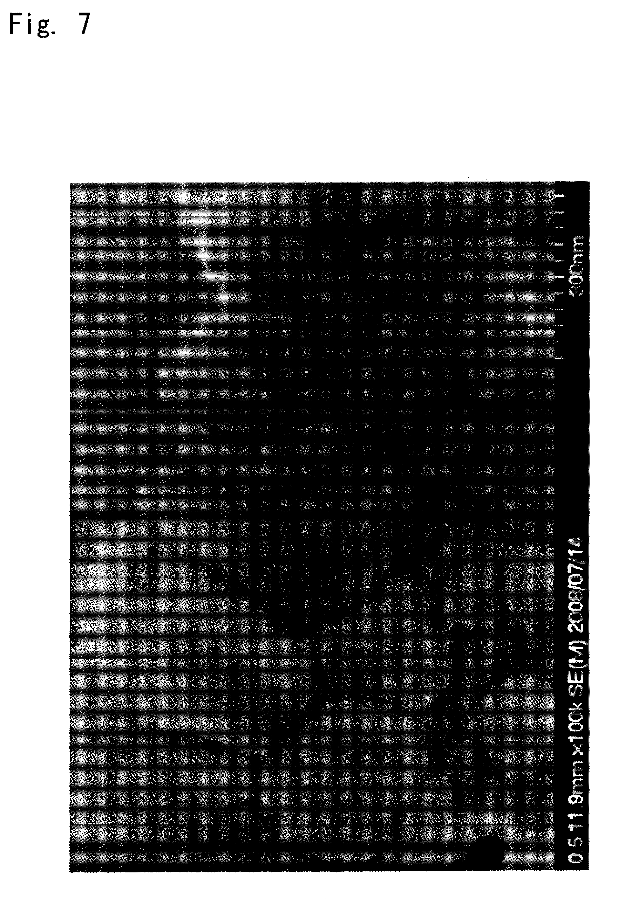

The observation of the baked films showed that the differences in volume resistivity value were caused by the differences in low temperature sinterability. Figs. 5, 6, and 7 are referred to. Fig. 5 is a surface SEM photograph of a film of a paste prepared using the powder of Example 1 after baking in air at 150˚C for 60 minutes (Example 2 (150)), and Fig. 6 is a surface SEM photograph of a film of a paste prepared using the powder of Example 1 after baking in air at 200˚C for 60 minutes (Example 2 (200). The arrows in Figs. 5 and 6 represent 600 nm. Fig. 7 is a surface SEM photograph of a coating of a paste prepared using the powder of Example 1 after drying in air at 100˚C for 60 minutes and baking in air at 150˚C for 30 minutes (Example 3). The arrows in Fig. 7 represent 300 nm. The clusters in the photographs are of the order of several hundred nm, and it was found that the baked films were formed of submicron size sintered particle clusters.

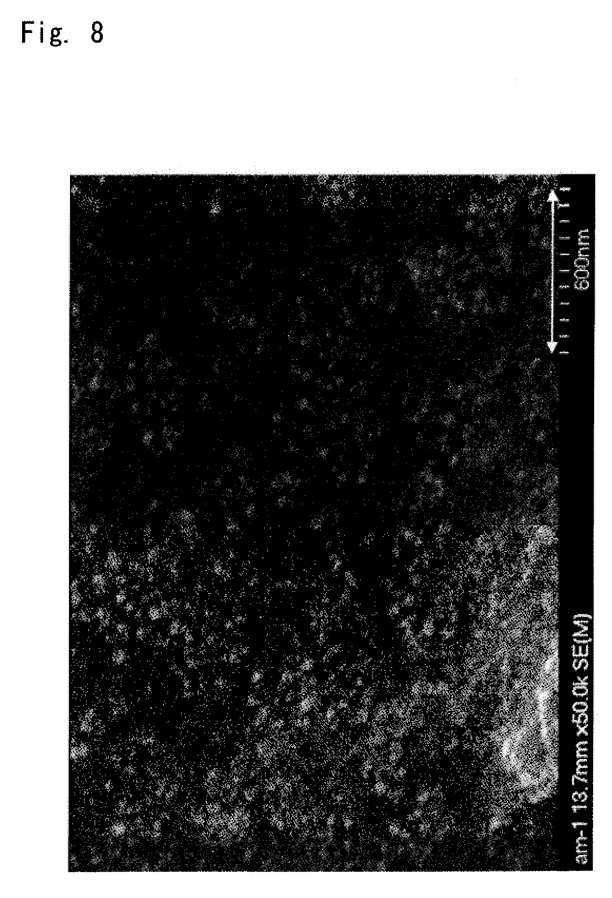

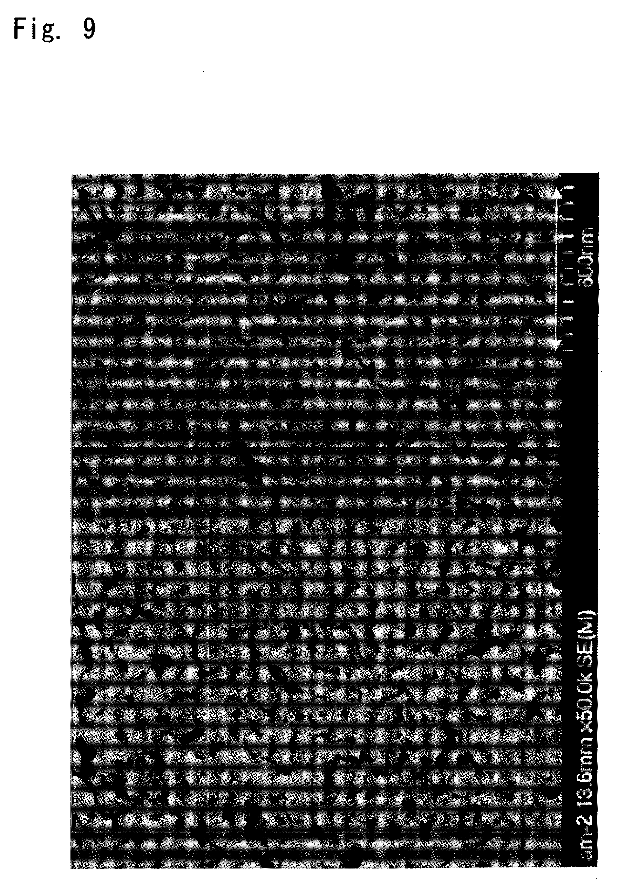

Fig. 8 is a surface SEM image of a baked film produced by baking a coating of a paste prepared using the powder of Comparative Example 1 in air at 150˚C for 60 minutes (Comparative Example 2 (150)), and Fig. 9 is a surface SEM image of a baked film produced by baking a coating of the paste prepared using the powder of Comparative Example 1 in air at 200˚C for 60 minutes (Comparative Example 2 (200)). The arrows represent 600 nm. The clusters in the photographs are of the order of several tens nm, and many nanometer size particles are found even after baking. These results showed that, in the Comparative Examples, sintering did not proceed during baking even at 200˚C. As can be seen from the above results, when the $\rho_f$ value is low as in the metal nanoparticle-containing composition of the present invention, the low temperature sinterability is good.

Next, Fig. 2 is referred to. In Fig. 2, the horizontal axis represents the ratio of $\rho_{150}$ or $\rho_{200}$ of the metal-containing composition of Example 1 to the density $\rho_M$ in a bulk form, and the vertical axis represents the volume resistivity. As in Fig. 1, the triangle represents a sample when the silver powder of Comparative Example 1 was baked in air at 200˚C for 60 minutes (Comparative Example 2 (200)); the square represents a sample when the silver powder of Example 1 was baked in air at 200˚C for 60 minutes (Comparative Example 1 (200)); and the diamond represents a sample when the silver powder of Example 1 was baked in air at 150˚C for 60 minutes (Example 2 (150)).

In the sample (square) produced by baking the Example in air at 200˚C for 60 minutes, the ratio of the density to that in a bulk form was close to 1, and the volume resistivity was also smallest. In the sample (diamond) produced by baking the Example in air at 150˚C for 60 minutes, the ratio of the density to that in a bulk form was about 0.98, which is not as close to 1 as the density ratio after baking at 200˚C. The volume resistivity was higher than that after baking at 200˚C. The Comparative Examples had the ratio of the density to that in a bulk form that was about 0.87, and the volume resistivity that was higher than that when the Example was baked at 150˚C (diamond).

The above results show that, when the ratio of the density of the baked product of the metal-containing composition to the density in a bulk form is close to 1.00, the baked product is close to silver in a bulk form. This indicates that, as the protective agent adhering to the metal surface evaporates, sintering of the metal particles proceeds even at low temperatures.

As described above, the metal nanoparticle-containing composition of the present invention has good low temperature sinterability, and therefore a sintered film having a low resistivity value can be obtained even by low temperature sintering.

INDUSTRIAL APPLICABILITY

The metal nanoparticle-containing composition of the present invention has good low temperature sinterability, and a circuit wiring pattern having low resistivity can be produced by printing the pattern with the composition on a substrate such as a paper or PET substrate. The metal particles in accordance with the present invention can be used in applications such as formation of electrodes for FPDs, solar batteries, and organic EL devices, formation of wiring for RFID, embedded wiring for, for example, fine trenches, via holes, and contact holes, coloring materials for coating cars and ships, carriers for adsorbing biochemical materials in medical, diagnostic, and biotechnological fields, antimicrobial coatings utilizing an antibacterial action, and catalysts. In addition, since the metal nanoparticle-containing composition has good low temperature sinterability and conductivity, it can be used in applications such as conductive adhesives used as substitutes for solder, conductive pastes prepared by mixing with resin, flexible printed circuit boards produced using the conductive pastes, highly flexible shields, and capacitors.

**Claims**

1. A metal-containing composition, comprising fine metal particles having an average particle diameter of less than 100 nm, wherein
$\rho_f$ is 1.10 or less where $\rho_f$ is a ratio of a true density $\rho_{200}$ to a true density $\rho_{150}$ ($\rho_{200}/\rho_{150}$), $\rho_{150}$, is the true density of the metal-containing composition after heating in air at 150˚C for 60 minutes, and $\rho_{200}$ is the true density of the metal-containing composition after heating in air at 200˚C for 60 minutes.

2. The metal-containing composition according to claim 1, wherein a ratio of $\rho_{150}$ to $\rho_M$ ($\rho_{150}/\rho_M$) and/or a ratio of $\rho_{200}$ to $\rho_M$ ($\rho_{200}/\rho_M$) is 0.8 or more, where $\rho_M$, is a density of the fine metal particles in a bulk form.

3. The metal-containing composition according to claim 1 or 2, wherein the fine metal particles have surfaces with an organic material with a molecular weight of 200 or less adhering thereto.

4. The metal-containing composition according to any one of claims 1 to 3, wherein the fine metal particles are formed from a compound and/or a single substance containing at least one of gold, silver and copper.

5. A conductive paste comprising the metal-containing composition according to any one of claims 1 to 4.

6. A metal film obtained by baking the metal-containing composition according to any one of claims 1 to 4.

7. A method for manufacturing a metal-containing composition, comprising:

a reducing solution preparing step of preparing a reducing solution by mixing water, ammonia water, an organic material having a molecular weight of 200 or less, and a reducing agent;
a reaction step of adding an aqueous solution of a metal salt to the reducing solution to allow a reaction to occur; and
a filtrating-washing step of filtrating a product obtained in the reaction step and washing the product with water.

Fig. 1

EP 2 311 586 A1

Fig. 2

Fig. 3

Fig. 4

Fig. 5

Fig. 6

Fig. 7

Fig. 8

Fig. 9

**INTERNATIONAL SEARCH REPORT**

| International application No. |
| --- |
| PCT/JP2008/064256 |

| A. CLASSIFICATION OF SUBJECT MATTER |
| --- |
| *B22F1/00* (2006.01) i |
| |
| According to International Patent Classification (IPC) or to both national classification and IPC |

| B. FIELDS SEARCHED |
| --- |
| Minimum documentation searched (classification system followed by classification symbols) |
| B22F1/00 |
| |
| Documentation searched other than minimum documentation to the extent that such documents are included in the fields searched |
| Jitsuyo Shinan Koho 1922-1996 Jitsuyo Shinan Toroku Koho 1996-2008 |
| Kokai Jitsuyo Shinan Koho 1971-2008 Toroku Jitsuyo Shinan Koho 1994-2008 |
| Electronic data base consulted during the international search (name of data base and, where practicable, search terms used) |
| |

| C. DOCUMENTS CONSIDERED TO BE RELEVANT |
| --- |

| Category* | Citation of document, with indication, where appropriate, of the relevant passages | Relevant to claim No. |
| --- | --- | --- |
| Y | JP 2006-183072 A (Namics Corp.), 13 July, 2006 (13.07.06), Claims; Par. No. [0035] (Family: none) | 1-7 |
| Y | JP 2008-133527 A (Toda Kogyo Corp.), 12 June, 2008 (12.06.08), Claims; Par. No. [0012] (Family: none) | 1-7 |
| Y | JP 04-333504 A (Sumitomo Metal Mining Co., Ltd.), 20 November, 1992 (20.11.92), Claims (Family: none) | 7 |

| ☐ Further documents are listed in the continuation of Box C. | ☐ See patent family annex. |
| --- | --- |

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| 04 November, 2008 (04.11.08) | 11 November, 2008 (11.11.08) |

| Name and mailing address of the ISA/ | Authorized officer |
| --- | --- |
| Japanese Patent Office | |
| Facsimile No. | Telephone No. |

Form PCT/ISA/210 (second sheet) (April 2007)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2007095510 A
- JP 2006028637 A

- JP 2007263860 A